# FASCICULE DE BREVET EUROPEEN

(11) **EP 3 804 120 B1**
(45) Date de publication et mention de la délivrance du brevet: **25.09.2024**
(21) Numéro de dépôt: 19734259.5
(22) Date de dépôt: 06.06.2019
(51) Int. Cl.: H02S 20/10, H01L 31/048, H01L 31/042

(54) **INSTALLATION PHOTOVOLTAIQUE ET PROCEDE DE POSE D'UNE INSTALLATION PHOTOVOLTAIQUE**
PHOTOVOLTAIKANLAGE UND VERFAHREN ZUR INSTALLATION EINER PHOTOVOLTAIKANLAGE
PHOTOVOLTAIC FACILITY AND METHOD FOR INSTALLING A PHOTOVOLTAIC FACILITY

(30) Priorité: 08.06.2018 FR 1800581
(43) Date de publication de la demande: 14.04.2021
(73) Titulaire: TOTAL SE, 92400 Courbevoie (FR)
(72) Inventeur: LEROY, Frédéric, 94300 Vincennes (FR); CASSAGNE, Valérick, 91470 Limours (FR)
(74) Mandataire: Innovincia
(86) Numéro de dépôt international: PCT/EP2019/064892
(87) Numéro de publication internationale: WO 2019/234201

(56) Documents cités:
- EP-A2- 2 432 030
- WO-A1-2007/141773
- WO-A1-2015/192126
- WO-A2-2009/062178
- WO-A2-2011/148139
- FR-A1- 3 056 827
- US-A1- 2010 065 106

## Description

La présente invention concerne une installation photovoltaïque pour un terril de déchets. L'invention concerne également un procédé de pose d'une telle installation photovoltaïque.

Certains déchets, tels que les terrils de déchets produits par l'exploitation minière, sont stockés sous forme de monticules pouvant atteindre des dimensions importantes et pouvant être répartis sur de larges surfaces. Ces larges surfaces ainsi dédiées au seul stockage des déchets sont très peu valorisées.

Ces monticules sont en outre exposés à la pluie. L'eau de pluie peut s'infiltrer dans le monticule et ainsi affecter la qualité des eaux souterraines du fait de la potentielle présence d'éléments contaminants dans ces déchets. L'eau de pluie infiltrée doit alors être traitée avant d'être réintroduite dans les nappes phréatiques, ce qui est coûteux.

Pour éviter cela, on recouvre les monticules de bâches d'étanchéité, comme expliqué par exemple dans la demande de brevet WO2011/148139 dans laquelle le monticule de déchet comprend notamment des matériaux en décomposition pouvant potentiellement contaminer l'eau de pluie si celle-ci entre en contact avec les détrituts accumulés. Le document WO 2011/148139 A2 divulgue une bâche d'étanchéité destinée à recouvrir au moins partiellement un monticule avec au moins deux modules flexibles photovoltaïques interconnectés entre eux et fixés sur la bâche d'étanchéité par collage.

Les pentes et les bâches des monticules permettent de dévier l'eau de pluie pour la collecter, l'empêchant ainsi de s'infiltrer. Les bâches sont de plus équipées de modules photovoltaïques flexibles configurés pour convertir de l'énergie solaire en énergie électrique, valorisant ainsi les grandes surfaces des monticules de déchets. De tels modules photovoltaïques associés à des bâches sont notamment dévoilés par la demande de brevet WO2015/192126. Cependant, les cellules photovoltaïques de ces modules comprennent du silicium sous forme de couches mince de silicium amorphe. Le rendement de ces structures de silicium en terme de conversion d'énergie par effet photovoltaïque n'est pas très élevé et relativement coûteux. De plus, déposer de telles cellules photovoltaïques sur des substrats souples destinés à être courbés en flexion peut potentiellement entraîner un dysfonctionnement ou une casse de ces cellules photovoltaïques.

La présente invention vise à fournir un moyen moins coûteux et avec un meilleur rendement pour mieux valoriser ces grandes surfaces disponibles dans le cas des terrils de déchets composés de matériaux inertes et non décomposables.

A cet effet, l'invention a pour objet une installation photovoltaïque comportant une bâche d'étanchéité destinée à recouvrir au moins partiellement un terril de déchets, et au moins deux modules flexibles photovoltaïques comprenant des cellules photovoltaïques à base de silicium monocristallin ou multi-cristallin, les au moins deux modules flexibles photovoltaïques étant interconnectés entre eux et fixés sur la bâche d'étanchéité par collage, caractérisée en ce qu'elle comporte au moins une boite de jonction de forme générale parallélépipédique présentant :
- une face de contact configurée pour être disposée au contact d'une surface du module flexible photovoltaïque,
- une face de connexion disposée perpendiculairement à la face de contact et présentant au moins une ouverture configurée pour permettre le passage d'au moins un câble de connexion,
- une face de fixation comprenant au moins un moyen de fixation d'un câble de retour de chaîne de l'installation photovoltaïque à la boite de jonction, ladite face de fixation étant disposée perpendiculairement à la face de contact et à la face de connexion.

Ainsi, on comprend que la bâche d'étanchéité permet d'étanchéifier le terril de déchets, empêchant l'infiltration de l'eau de pluie, tandis que les modules flexibles photovoltaïques disposés sur la bâche permettent de produire de l'énergie solaire avec un rendement plus élevé.

L'installation photovoltaïque bénéficie ainsi de la pente disponible des terrils de déchets, généralement élevée pour collecter l'eau de pluie, telle que de l'ordre de 20° à 40°. Cette pente donne une orientation favorable aux modules flexibles pour une production performante d'électricité solaire et pour un lavage naturel par la pluie drainée par la pente.

L'installation photovoltaïque profite également des importantes surfaces de stockage des déchets disponibles jusqu'alors peu valorisées.

La légèreté des modules flexibles photovoltaïques permet en outre de ne pas contraindre mécaniquement la bâche d'étanchéité.

La disposition en surface de la bâche d'étanchéité évite les structures pénétrantes qui peuvent présenter des risques de défauts d'étanchéité et des problématiques de qualité des fondations dans les terrils ou les décharges.

La flexibilité des modules permet en outre aux modules de s'adapter à la topologie du terrain.

La structure monocristastlline ou mullti-cristalline du silicium permet d'avoir un meilleur rendement qu'une structure de silicium amorphe.

Par ailleurs, la fixation des modules flexibles par collage est un procédé d'assemblage qui est peu agressif. On réduit ainsi les risques d'endommagements de la bâche d'étanchéité au moment de la fixation des modules. De plus, la fixation par collage peut être facilement réversible, de sorte qu'il est possible de retirer un module flexible pour le remplacer si nécessaire sans toutefois endommager l'étanchéité de la bâche ou encore de recoller un nouveau module sur le module dysfonctionnant.

La colle de l'installation photovoltaïque interposée entre les modules flexibles photovoltaïques et la bâche d'étanchéité comporte par exemple du butyle. Ce type de colle ne flue pas une fois posée.

Selon un exemple de réalisation, les au moins deux modules flexibles photovoltaïques sont respectivement formés d'un laminât flexible de cellules photovoltaïques comprenant une couche de cellules photovoltaïques connectées entre elles, une couche frontale et une couche arrière d'encapsulation prenant en sandwich la couche de cellules photovoltaïques.

Selon un exemple particulier de réalisation, les au moins deux modules flexibles photovoltaïques comportent respectivement au moins un empilement de couches dans l'ordonnancement suivant :
- une couche translucide se présentant en avant du panneau,
- une couche de tissu sec en fibres de verre,
- une couche de tissu de fibre de verre pré-imprégné de résine époxy,
- une couche de cellules photovoltaïques,
- une seconde couche de tissu sec en fibres de verre, et
- une seconde couche de tissu de fibre de verre pré-imprégné de résine époxy,
- une couche en arrière du panneau.

L'invention a aussi pour objet un procédé de pose d'une installation photovoltaïque telle que décrite précédemment dans lequel on colle les au moins deux modules flexibles photovoltaïques après avoir disposé la bâche d'étanchéité sur le terril de déchets.

On facilite ainsi la pose de l'installation photovoltaïque sur le terril de déchets.

En effet, la fixation des modules sur la bâche alors que cette dernière est déjà agencée sur un terril de déchets est plus simple à réaliser par collage, notamment par rapport à une fixation par soudure qui serait plus délicate à mettre en oeuvre sur site.

De même, la pose de la bâche d'étanchéité sur le terril est plus simple à réaliser sans modules fixés au préalable. La pose ultérieure des modules permet d'avoir des bâches d'étanchéité moins lourdes pour le transport et la pose, pouvant en outre être pliées pendant ces opérations.

De plus, fixer les modules flexibles après avoir disposé la bâche permet un calepinage plus juste par rapport à la réalité de la topologie et du positionnement effectif des bâches, en évitant notamment d'éventuels décalages.

En outre, des modules flexibles collés après la pose de la bâche sont moins sollicités mécaniquement, ce qui rend l'installation plus robuste.

Par ailleurs, on peut prévoir de limiter le rayon de courbure des modules flexibles photovoltaïques collés sur la bâche d'étanchéité à 20 cm.

D'autres caractéristiques et avantages de la présente invention apparaîtront plus clairement à la lecture de la description suivante, donnée à titre illustratif et non limitatif, et des dessins annexés dans lesquels :
La Figure 1 est une représentation schématique d'une installation photovoltaïque disposée sur un terril de déchets.
La Figure 2 est une représentation schématique en coupe d'une portion de l'installation photovoltaïque.
La Figure 3 est une représentation schématique de dessus d'un module flexible photovoltaïque.
La Figure 4 est une représentation schématique en coupe transversale d'un module flexible photovoltaïque selon un premier exemple de réalisation.
La Figure 5 est une représentation schématique en coupe transversale d'un module flexible photovoltaïque selon un deuxième exemple de réalisation.
La Figure 6 montre une autre représentation schématique de l'installation photovoltaïque.
La Figure 7 montre une représentation schématique d'une boite de jonction selon un exemple de réalisation.
La Figure 8 montre une vue schématique d'étapes d'un procédé de pose d'une installation photovoltaïque.

Sur ces Figures, les éléments identiques portent les mêmes références numériques.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées et/ou interchangées pour fournir d'autres réalisations, sans s'écarter de la portée de l'invention, telle que définie par les revendications.

On entend par « couche frontale » dans la description suivante, la surface du module flexible exposée en premier aux rayons solaires lorsque le module flexible est installé. De même, on entend par « couche arrière » dans la description suivante, la couche opposée à la couche frontale, c'est-à-dire la surface qui est impactée en dernier par les rayons solaires lors de leur passage à travers le module installé.

On entend dans la description suivante par « flexible » le fait que lors de l'application d'un certain rayon de courbure, le module ne se fissure pas. Dans la présente invention le module devrait supporter sans dommage un rayon de courbure de 50 cm.

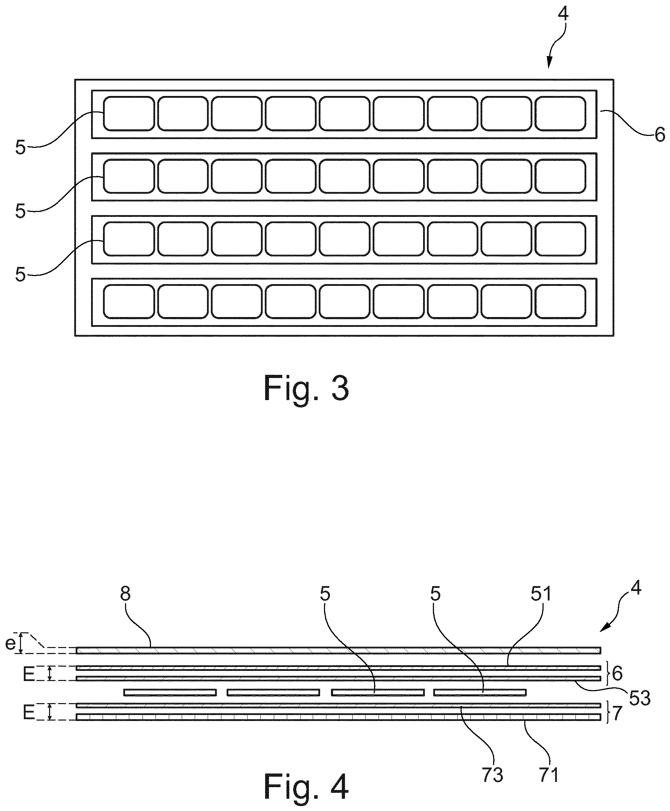

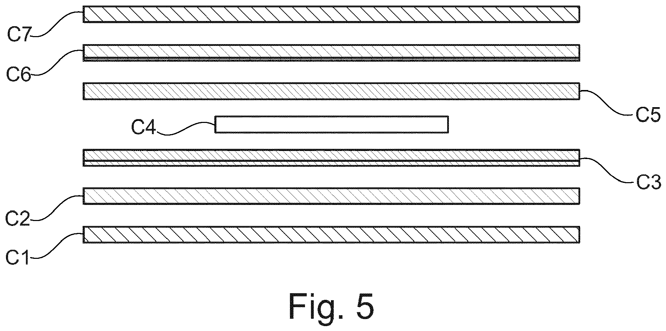

D'autre part, en référence aux Figures 4 et 5, les différentes couches composant un module flexible sont espacées les unes des autres. Cette représentation est uniquement réalisée pour mieux identifier les différentes couches. A l'état installé, les différentes couches représentées sont en contact les unes avec les autres.

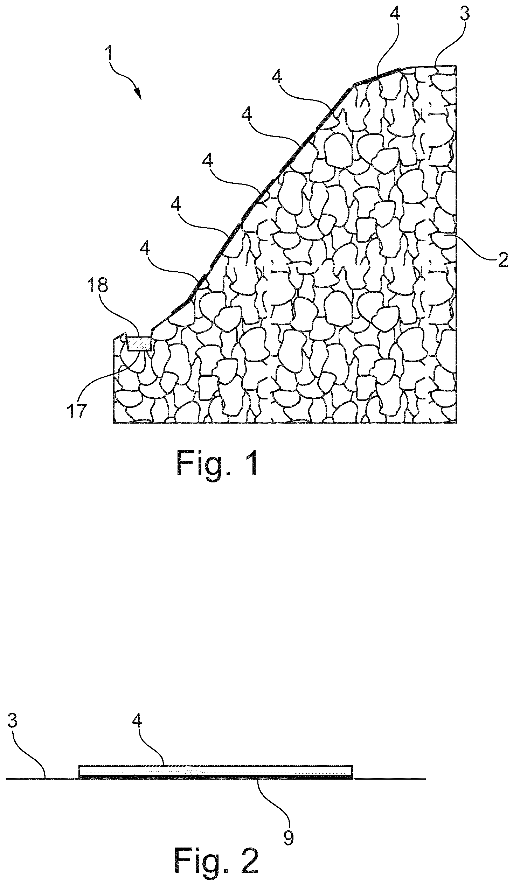

La Figure 1 montre une installation photovoltaïque 1 disposée sur un terril de déchets 2. Le terril de déchets est majoritairement composé de déchets inertes solides et de nature minérale, tels que des déchets issus de carrières

L'installation photovoltaïque 1 comporte une bâche d'étanchéité 3 destinée à recouvrir au moins partiellement le terril de déchets 2. La bâche 3 peut également recouvrir un canal 17 formé par exemple au pied du terril 2, pour drainer l'eau de pluie 18.

La bâche d'étanchéité 3 est imperméable. Elle comporte par exemple un ou plusieurs polymère(s), tel que du polyéthylène (PE), bitume, polyoléfine (TPO), éthylène-propylène-diène (EPDM) ou polychlorure de vinyle (PVC). Ces matériaux polymères peuvent éventuellement être armés de fibres et/ou être multicouches.

L'installation photovoltaïque 1 comporte en outre au moins deux modules flexibles photovoltaïques 4 (ou panneau flexibles photovoltaïques) comprenant des cellules photovoltaïques 5 à base de silicium monocristallin ou multi-cristallin, les deux modules flexibles photovoltaïques 4 étant interconnectés entre eux et fixés par collage sur la bâche d'étanchéité 3. La colle 9 interposée entre les modules flexibles photovoltaïques 4 et la bâche d'étanchéité 3 (Figure 2) comporte par exemple du butyle. Ce type de colle ne flue pas une fois posée.

Un module flexible photovoltaïque 4 comporte des cellules photovoltaïques 5 par exemple à base de silicium monocristallin ou multi-cristallin, aptes à convertir le rayonnement électromagnétique du soleil en énergie électrique grâce à l'effet photovoltaïque des composants de ces cellules photovoltaïques.

Selon un exemple de réalisation visible sur les Figures 3 et 4, les modules flexibles photovoltaïques 4 sont respectivement formés d'un laminât flexible de cellules photovoltaïques 5 comprenant une couche de cellules photovoltaïques 5 connectées entre elles, une couche frontale 6 et une couche arrière 7 d'encapsulation prenant en sandwich la couche de cellules photovoltaïques 5. Ce laminât flexible peut par exemple être obtenu par un procédé de lamination classique, c'est-à-dire par élévation de la température d'un empilement des différentes couches formant le laminât puis par pression sur cet empilement pendant une durée prédétermine par exemple sous vide ou sous une atmosphère inerte.

En référence à la Figure 4, les couches frontale 6 et arrière 7 d'encapsulation comprennent chacune un tissu de fibres de verre 51, 71 et une résine d'encapsulation 53, 73. Plus particulièrement, la résine d'encapsulation 53, 73 est disposée entre la couche de cellules photovoltaïques 5 et le tissu de fibres de verre 51, 71 afin d'assurer la cohésion entre le tissu de fibres de verre 51, 71 et la couche de cellules photovoltaïques 5. A titre de variante, chacune des deux couches frontales 6 et arrière 7 peut être formé d'une seule couche de tissu en fibre de verre imprégné.

Au moins la couche frontale 6 d'encapsulation est transparente pour permettre aux rayons solaires d'atteindre la couche de cellules photovoltaïques 5 afin de permettre leur conversion de l'énergie photovoltaïque en énergie électrique.

Lorsque le laminât flexible est installé, les rayons solaires pénètrent d'abord la couche frontale 6 d'encapsulation, puis la couche des cellules photovoltaïques 5 et enfin, s'ils ne sont pas absorbés, la couche arrière d'encapsulation 7.

Le module flexible 4 peut en outre comporter un film externe 8 en matériau souple et transparent, disposé sur la couche frontale 6 d'encapsulation. Le film externe permet d'augmenter l'étanchéité du laminat à l'humidité et/ou de former une barrière au rayonnement ultraviolet et/ou de limiter l'encrassement du module 4 du fait de l'exposition du laminât flexible 4 aux agressions climatiques et aux poussières.

Les couches frontale 6 et arrière 7 d'encapsulation présentent par exemple chacune une épaisseur E comprise entre 0,05 mm et 3 mm. Une telle épaisseur E des couches frontale 6 et arrière 7 d'encapsulation permet l'obtention d'un laminât flexible de faible épaisseur, ce qui permet notamment de diminuer les coûts liés à son transport et son poids.

Selon un exemple particulier de réalisation, les modules flexibles photovoltaïques 4 sont respectivement réalisés comme décrit dans la demande de brevet WO2018/060611 dont le contenu est incorporé par référence dans la présente demande.

Le module flexible photovoltaïque 4 (ou panneau photovoltaïque dans la demande de brevet WO2018/060611) comporte au moins un empilement de couches dans l'ordonnancement suivant (Figure 5) :
- une couche translucide C1 se présentant en avant du panneau,
- une couche de tissu sec C2 en fibres de verre,
- une couche de tissu de fibre de verre C3 pré-imprégné de résine époxy,
- une couche de cellules photovoltaïques C4,
- une seconde couche de tissu sec C5 en fibres de verre, et
- une seconde couche de tissu de fibre de verre C6 pré-imprégné de résine époxy,
- une couche en arrière du panneau C7.

La couche avant C1 et/ou la couche arrière C7 peuvent être fabriquées en polymères.

Les couches translucide C1 se présentant en avant du panneau, de tissu sec C2 en fibres de verre, de tissu de fibre de verre C3 pré-imprégné de résine époxy forment une couche frontale d'encapsulation 6. Les couches de tissu sec C5 en fibres de verre, de tissu de fibre de verre C6 pré-imprégné de résine époxy et arrière du panneau C7 forment une couche arrière d'encapsulation 7.

Ce module 4 peut être obtenu par un procédé de fabrication d'un panneau de cellules photovoltaïques décrit dans la demande de brevet WO2018/060611. Le procédé de fabrication comporte une étape de cuisson d'un empilement d'une pluralité de couches comprenant des matériaux différents, et une étape d'empilement comportant la mise en place des couches suivantes :
- une couche avant translucide C1,
- au moins deux couches C2, C5 de tissu sec de fibres de verre,
- au moins deux couches C3, C6 de tissu de fibres de verre pré-imprégné de résine époxy,
- une couche de cellules photovoltaïques C4,
- une couche arrière C7, la couche avant translucide C1 et la couche de cellules photovoltaïques étant séparées par une couche C2, C5 de tissu sec de fibres de verre et une couche C3, C6 de tissu de fibres de verre pré-imprégné de résine époxy, la couche de cellules photovoltaïques C4 et la couche arrière étant également séparées par une couche C2, C5 de tissu sec de fibres de verre et une couche C3, C6 de tissu de fibres de verre pré-imprégné de résine époxy.

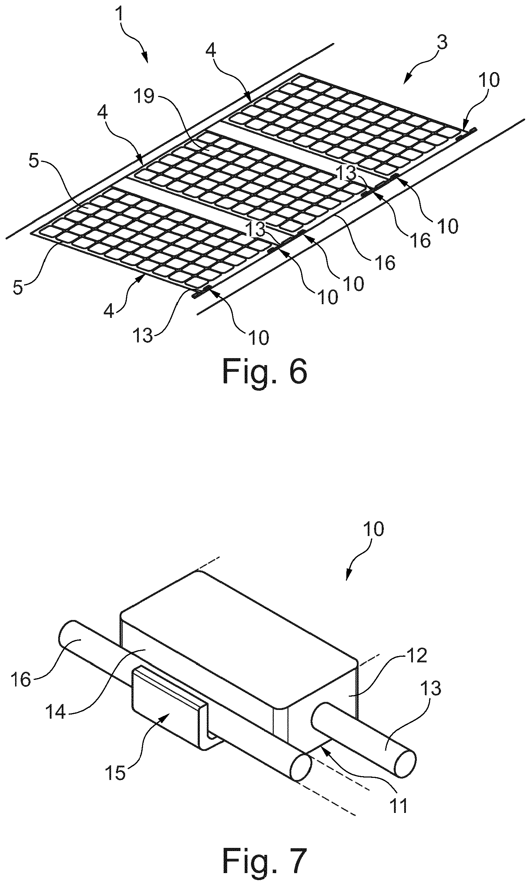

Pour relier l'installation photovoltaïque 1 notamment à un onduleur, l'installation photovoltaïque 1 peut comporter au moins une boite de jonction 10 (Figures 6 et 7).

La boite de jonction 10 de forme générale parallélépipédique présente :
- une face de contact 11 configurée pour être disposée au contact d'une surface du module flexible photovoltaïque 4,
- une face de connexion 12 disposée perpendiculairement à la face de contact 11 et présentant au moins une ouverture configurée pour permettre le passage d'au moins un câble de connexion 13,
- une face de fixation 14 comprenant au moins un moyen de fixation 15 d'un câble de retour de chaîne 16 de l'installation 1 à la boite de jonction 10, ladite face de fixation 14 étant disposée perpendiculairement à la face de contact 11 et à la face de connexion 12.

Le moyen de fixation 15 peut comporter un ou plusieurs crochets de retenue du câble de retour de chaîne 16, tel que des clips élastiques. La boite de jonction 10 peut être vissée, collée ou encliquetée sur la surface du module flexible photovoltaïque 4.

Les boites de jonction 10 peuvent être alignées.

L'installation photovoltaïque 1 peut comporter une ou plusieurs boites de jonction 10, par exemple deux, par module flexible photovoltaïque 4.

L'utilisation d'une telle boite de jonction 10 permet d'assurer la fixation du câble de retour de chaîne 16 et de garantir un chemin identique de l'énergie produite à l'aller et au retour entre le module flexible 4 et l'onduleur. D'autre part, la présence des moyens de fixation 15 permet de s'affranchir d'un câblage complexe, conséquent, coûteux et pouvant entraîner la présence de boucles d'induction.

Ainsi, on comprend que la bâche d'étanchéité 3 permet d'étanchéifier le terril de déchets 2, empêchant l'infiltration de l'eau de pluie, tandis que les modules flexibles photovoltaïques 4 disposés sur la bâche 3 permettent de produire de l'énergie solaire.

L'installation photovoltaïque 1 bénéficie ainsi de la pente disponible des terrils de déchets 2, généralement élevée pour collecter l'eau de pluie, telle que de l'ordre de 20° à 40°. Cette pente donne une orientation favorable aux modules flexibles 4 pour une production performante d'électricité solaire et pour un lavage naturel par la pluie drainée par la pente.

L'installation photovoltaïque 1 profite également des importantes surfaces de stockage des déchets disponibles jusqu'alors peu valorisées.

La légèreté des modules flexibles photovoltaïques 4 permet en outre de ne pas contraindre mécaniquement la bâche d'étanchéité 3.

La disposition en surface de la bâche d'étanchéité 3 évite les structures pénétrantes qui peuvent présenter des risques de défauts d'étanchéité et des problématiques de qualité des fondations dans les terrils ou les décharges.

La flexibilité des modules 4 permet en outre aux modules 4 de s'adapter à la topologie du terrain.

Par ailleurs, la fixation des modules flexibles 4 par collage est un procédé d'assemblage qui est peu agressif. On réduit ainsi les risques d'endommagements de la bâche d'étanchéité 3 au moment de la fixation des modules 4. De plus, la fixation par collage peut être réversible, de sorte qu'il est possible de retirer un module flexible 4 pour le remplacer si nécessaire sans toutefois endommager l'étanchéité de la bâche 3 ou encore de recoller un nouveau module sur le module dysfonctionnant.

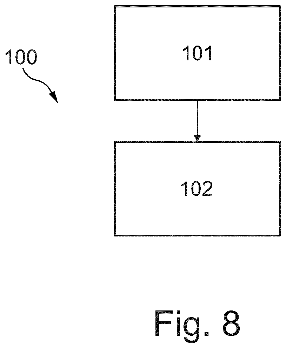

Lors de la pose de l'installation photovoltaïque 1, il est en outre possible de coller les modules flexibles photovoltaïques 4 sur la bâche d'étanchéité 3 (Figure 8, étape 102 du procédé de pose d'une installation photovoltaïque 100) après l'avoir disposée sur le terril de déchets 2 (Figure 8, étape 101).

En effet la fixation des modules 4 sur la bâche 3 alors que cette dernière est déjà agencée sur un terril de déchets 2 est plus simple à réaliser par collage, notamment par rapport à une fixation par soudure qui serait plus délicate à mettre en oeuvre sur site.

De même, la pose de la bâche d'étanchéité 3 sur le terril 2 est plus simple à réaliser sans modules flexibles 4 fixés au préalable. La pose ultérieure des modules permet d'avoir des bâches d'étanchéité moins lourdes pour le transport et la pose, pouvant en outre être pliées pendant ces opérations.

De plus, fixer les modules flexibles 4 après avoir disposé la bâche 3 permet un calepinage plus juste par rapport à la réalité de la topologie et du positionnement effectif des bâches 3, en évitant notamment d'éventuels décalages.

Egalement, des modules flexibles 4 collés après la pose de la bâche 3 sont moins sollicités mécaniquement, ce qui rend l'installation photovoltaïque 1 plus robuste.

On peut en outre prévoir de limiter le rayon de courbure des modules flexibles photovoltaïques 4 collés sur la bâche d'étanchéité 3 disposée sur le terril de déchets 2 à 20 cm pour augmenter la durabilité et la tenue mécanique des modules 4.

## Revendications

1. Installation photovoltaïque (1) comportant une bâche d'étanchéité (3) destinée à recouvrir au moins partiellement un terril de déchets, et au moins deux modules flexibles photovoltaïques (4) comprenant des cellules photovoltaïques (5) à base de silicium monocristallin ou multi-cristallin, les au moins deux modules flexibles photovoltaïques (4) étant interconnectés entre eux et fixés sur la bâche d'étanchéité (3) par collage, **caractérisée en ce qu'**elle comporte au moins une boite de jonction (10) de forme générale parallélépipédique présentant :
- une face de contact (11) configurée pour être disposée au contact d'une surface du module flexible photovoltaïque (4),
- une face de connexion (12) disposée perpendiculairement à la face de contact (11) et présentant au moins une ouverture configurée pour permettre le passage d'au moins un câble de connexion (13),
- une face de fixation (14) comprenant au moins un moyen de fixation (15) d'un câble de retour de chaîne (16) de l'installation photovoltaïque (1) à la boite de jonction (1), ladite face de fixation (14) étant disposée perpendiculairement à la face de contact (11) et à la face de connexion (12).

2. Installation photovoltaïque (1) selon la revendication précédente, **caractérisée en ce que** la colle (9) de l'installation photovoltaïque (1) interposée entre les modules flexibles photovoltaïques (4) et la bâche d'étanchéité (3) comporte du butyle.

3. Installation photovoltaïque (1) selon l'une des revendications précédentes, **caractérisée en ce que** les au moins deux modules flexibles photovoltaïques (4) sont respectivement formés d'un laminât flexible de cellules photovoltaïques (5) comprenant une couche de cellules photovoltaïques (5) connectées entre elles, une couche frontale (6) et une couche arrière (7) d'encapsulation prenant en sandwich la couche de cellules photovoltaïques (5).

4. Installation photovoltaïque (1) selon l'une des revendications précédentes, **caractérisée en ce que** les au moins deux modules flexibles photovoltaïques (4) comportent respectivement au moins un empilement de couches dans l'ordonnancement suivant :
- une couche translucide (C1) se présentant en avant du panneau,
- une couche de tissu sec (C2) en fibres de verre,
- une couche de tissu de fibre de verre (C3) pré-imprégné de résine époxy,
- une couche de cellules photovoltaïques (C4),
- une seconde couche de tissu sec (C5) en fibres de verre, et
- une seconde couche de tissu de fibre de verre (C6) pré-imprégné de résine époxy,
- une couche en arrière du panneau (C7).

5. Installation photovoltaïque (1) selon l'une des revendications précédentes, **caractérisée en ce que** la boite de jonction (10) est vissée, collée, ou encliquetée sur la surface du module flexible photovoltaïque.

6. Procédé de pose d'une installation photovoltaïque (100) selon l'une des revendications précédentes dans lequel on colle les au moins deux modules flexibles photovoltaïques (4) après avoir disposé la bâche d'étanchéité (3) sur le terril de déchets (2).

7. Procédé de pose d'une installation photovoltaïque (100) selon la revendication précédente, dans lequel on limite le rayon de courbure des modules flexibles photovoltaïques (4) collés sur la bâche d'étanchéité (3) à 20 cm.

## Patentansprüche

1. Photovoltaikanlage (1), die eine Abdichtungsplane (3), die dazu bestimmt ist, eine Abfallhalde mindestens teilweise zu bedecken, und mindestens zwei flexible Photovoltaikmodule (4) aufweist, die Photovoltaikzellen (5) auf der Basis von monokristallinem oder multikristallinem Silicium enthalten, wobei die mindestens zwei flexiblen Photovoltaikmodule (4) miteinander verbunden und durch Kleben an der Abdichtungsplane (3) befestigt sind, **dadurch gekennzeichnet, dass** sie mindestens einen Verteilerkasten (10) von allgemein parallelepipedischer Form aufweist, der enthält:
- eine Kontaktseite (11), die konfiguriert ist, in Kontakt mit einer Fläche des flexiblen Photovoltaikmoduls (4) angeordnet zu werden,
- eine Verbindungsseite (12), die lotrecht zur Kontaktseite (11) angeordnet ist und mindestens eine Öffnung aufweist, die konfiguriert ist, den Durchgang mindestens eines Verbindungskabels (13) zu erlauben,
- eine Befestigungsseite (14), die mindestens eine Befestigungseinrichtung (15) eines String-Rückführkabels (16) der Photovoltaikanlage (1) am Verteilerkasten (1) enthält, wobei die Befestigungsseite (14) lotrecht zur Kontaktseite (11) und zur Verbindungsseite (12) angeordnet ist.

2. Photovoltaikanlage (1) nach dem vorhergehenden Anspruch, **dadurch gekennzeichnet, dass** der Klebstoff (9) der Photovoltaikanlage (1), der zwischen die flexiblen Photovoltaikmodule (4) und die Abdichtungsplane (3) eingefügt ist, Butyl enthält.

3. Photovoltaikanlage (1) nach einem der vorhergehenden Ansprüche, wobei die mindestens zwei flexiblen Photovoltaikmodule (4) je von einem flexiblen Laminat von Photovoltaikzellen (5) geformt werden, das eine Schicht von miteinander verbundenen Photovoltaikzellen (5), eine frontale (6) und eine hintere Einkapselungsschicht (7) enthält, die die Schicht von Photovoltaikzellen (5) sandwichartig einschließen.

4. Photovoltaikanlage (1) nach einem der vorhergehenden Ansprüche, **dadurch gekennzeichnet, dass** die mindestens zwei flexiblen Photovoltaikmodule (4) je mindestens einen Stapel von Schichten in der folgenden Reihenfolge aufweisen:
- eine lichtdurchlässige Schicht (C1), die sich vor dem Paneel befindet,
- eine Schicht von trockenem Glasfasergewebe (C2),
- eine mit Epoxidharz vorimprägnierte Schicht von Glasfasergewebe (C3),
- eine Schicht von Photovoltaikzellen (C4),
- eine zweite Schicht von trockenem Glasfasergewebe (C5), und
- eine zweite Schicht von mit Epoxidharz vorimprägniertem Glasfasergewebe (C6),
- eine Schicht hinter dem Paneel (C7).

5. Photovoltaikanlage (1) nach einem der vorhergehenden Ansprüche, **dadurch gekennzeichnet, dass** der Verteilerkasten (10) auf die Fläche des flexiblen Photovoltaikmoduls geschraubt, geklebt oder eingerastet wird.

6. Einbauverfahren einer Photovoltaikanlage (100) nach einem der vorhergehenden Ansprüche, wobei die mindestens zwei flexiblen Photovoltaikmodule (4) geklebt werden, nachdem die Abdichtungsplane (3) auf der Abfallhalde (2) angeordnet wurde.

7. Einbauverfahren einer Photovoltaikanlage (100) nach dem vorhergehenden Anspruch, wobei der Krümmungsradius der auf die Abdichtungsplane (3) geklebten flexiblen Photovoltaikmodule (4) auf 20 cm begrenzt wird.

## Claims

1. Photovoltaic system (1) comprising a leaktight tarpaulin (3) intended to at least partially cover a waste heap, and at least two flexible photovoltaic modules (4) comprising photovoltaic cells (5) on the basis of monocrystalline or polycrystalline silicon, the at least two flexible photovoltaic modules (4) being interconnected and fixed to the leaktight tarpaulin (3) by adhesive bonding, **characterized in that** it comprises at least one junction box (10) of parallelepipedal overall shape, having:
- a contact face (11) configured to be placed in contact with a surface of the flexible photovoltaic module (4),
- a connection face (12) which is perpendicular to the contact face (11) and has at least one opening configured to allow the passage of at least one connection cable (13),
- a fixing face (14) comprising at least one fixing means (15) for fixing a chain return cable (16) of the photovoltaic system (1) to the junction box (1), said fixing face (14) being perpendicular to the contact face (11) and to the connection face (12).

2. Photovoltaic system (1) according to the preceding claim, **characterized in that** the adhesive (9) of the photovoltaic system (1) interposed between the flexible photovoltaic modules (4) and the leaktight tarpaulin (3) comprises butyl.

3. Photovoltaic system (1) according to either of the preceding claims, **characterized in that** the at least two flexible photovoltaic modules (4) are respectively formed of a flexible laminate of photovoltaic cells (5) comprising a layer of interconnected photovoltaic cells (5), a front layer (6) and a rear layer (7) for encapsulation sandwiching the layer of photovoltaic cells (5).

4. Photovoltaic system (1) according to one of the preceding claims, **characterized in that** the at least two flexible photovoltaic modules (4) respectively comprise at least one stack of layers in the following order:
- a translucent layer (C1) at the front of the panel,
- a dry fabric layer (C2) made of glass fibres,
- a fibreglass fabric layer (C3) pre-impregnated with epoxy resin,
- a layer of photovoltaic cells (C4),
- a second dry fabric layer (C5) made of glass fibres, and
- a second fibreglass fabric layer (C6) pre-impregnated with epoxy resin,
- a layer at the rear of the panel (C7).

5. Photovoltaic system (1) according to one of the preceding claims, **characterized in that** the junction box (10) is screwed, adhesively bonded, or snap-fastened to the surface of the flexible photovoltaic module.

6. Method for installing a photovoltaic system (100) according to one of the preceding claims, wherein the at least two flexible photovoltaic modules (4) are adhesively bonded after having placed the leaktight tarpaulin (3) on the waste heap (2).

7. Method for installing a photovoltaic system (100) according to the preceding claim, wherein the radius of curvature of the flexible photovoltaic modules (4) adhesively bonded to the leaktight tarpaulin (3) is limited to 20 cm.
